# EUROPÄISCHE PATENTANMELDUNG

(11) **EP 0 945 902 A1**
(43) Veröffentlichungstag der Anmeldung: **29.09.1999**
(21) Anmeldenummer: 99102695.6
(22) Anmeldetag: 12.02.1999
(51) Int. Cl.: H01L 27/108, H01L 21/8242, H01L 29/423

(54) **MOS-Transistor für DRAM-Speicherzelle und Herstellverfahren dafür**

(30) Priorität: 19.03.1998 DE 19812212
(71) Anmelder: SIEMENS AKTIENGESELLSCHAFT, 80333 München (DE)
(72) Erfinder: Heineck, Lars-Peter, 75012 Paris (FR); Schweeger, Giorgio, 91210 Draveil (FR)

(57) **Zusammenfassung**

Bei einem MOS-Transistor als Auswahltransistor in einer Ein-Transistor-Speicherzelle mit Nitridspacern (7)(oder einem anderen als Oxidationsbarriere wirkenden Spacermaterial) wird zur Reduzierung von Leckströmen ein bird's beak (5) am Gateoxid eingesetzt. Das Herstellverfahren sieht vor, den bird's beak (5) vor Erzeugung der Nitridspacer (7) herzustellen. Der MOS-Transistor kann insbesondere als Auswahltransistor in einem DRAM eingesetzt werden.

## Beschreibung

Die Erfindung betrifft einen MOS-Transistor als Auswahltransistor in einer Ein-Transistor-Speicherzelle und ein Herstellverfahren.

MOS-Transistoren bilden die Grundlage einer Vielzahl von integrierten Schaltungen wie Speicherschaltungen oder Logikschaltungen. Aufgrund der wachsenden Integrationsdichte von integrierten Schaltungen muß ihre Gatelänge, d.h. der Abstand der leitenden Gebiete des MOS-Transistors (Source und Drain) ständig verringert werden. Es ist Stand der Technik, das Gate mit einer Nitrideinkapselung zu versehen, also insbesondere die üblichen isolierenden Spacer an den Gateseitenwänden aus Nitrid zu bilden, um die Spacerdicke ohne Einbußen ihrer Isolationswirkung zu minimieren. Mithilfe von Nitridspacern oder einer Nitrid-Ätzstopschicht auf einer z.B. aus Oxid bestehenden oberen und seitlichen Gateisolation kann in bekannter Weise ein selbstjustierter Kontakt zu Source und Drain hergestellt werden, bei der die obere und seitliche Gateisolation nicht oder nur minimal angegriffen wird.

Die Verringerung der Gatelänge führt zu wachsenden Feldstärken und damit zu Problemen insbesondere bei der Spannungsfestigkeit und Zuverlässigkeit des Transistors aufgrund von Leckströmen.

Ein derartiger Transistor mit Nitrideinkapselung kann bspw. als Auswahltransistor in einer DRAM-Speicherzelle eingesetzt werden. Für DRAM-Speicher gibt es eine Vielzahl von Zellkonzepten, ein Beispiel ist eine sogenannte Grabenzelle mit Surface strap. Dabei wird der Speicherkondensator in einem Graben im Halbleitersubstrat ausgeführt, und die Speicherelektrode wird im Graben angeordnet. Das Kondensatordielektrikum bedeckt die Grabenwand. Der Auswahltransistor ist benachbart zum Graben angeordnet. Die elektrische Verbindung zwischen Speicherelektrode und einem dotierten Gebiet des Auswahltransistors erfolgt über eine der Substratoberfläche angeordnete Polysiliziumstruktur ( 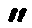 Surface strap"), die die Grabenauffüllung und das dotierte Gebiet überlappt.

Bei Ein-Transistor-Speicherzellen, insb. DRAM-Speicherzellen, hat ein Leckstrom insbesondere den sogenannten GIDL-Effekt (GIDL = Gate Induced Drain Leakage) zur Folge. Ein derartiger GIDL-Strom führt Absinken der Informationserhaltungszeit der Zelle (Retention Time), dies trifft insbesondere auf die Seite des Auswahltransistors zu, der mit der Speicherkapazität verbunden ist. Der GIDL-Strom muß daher minimiert werden.

Eine Maßnahme zur Reduzierung des GIDL-Effekts ist eine Verringerung der Diffusion der Ionenimplantationen unter das Gate. Dies geschieht durch Reduzierung der Hochtemperaturschritte nach den kritischen Implantationen (Implantation von Source und Drain). Ein wesentlicher Nachteil sind die damit verbundenen zusätzlichen Prozeßlimitationen. Eine andere Möglichkeit ist ein aufwendiges, komplettes Neudesign des Bausteins. Beide Maßnahmen sind jedoch nur eingeschränkt wirksam.

Aufgabe der vorliegenden Erfindung ist es daher, einen MOS-Transistor in einer Ein-Transistor-Speicherzelle mit einem als Oxidationsbarriere wirkenden isolierenden Spacer anzugeben, bei dem der GIDL-Effekt wirksam minimiert wird, sowie ein Herstellverfahren für einen derartigen MOS-Transistor. Diese Aufgabe wird durch einen Transistor mit den Merkmalen des Patentanspruchs 1 und durch ein Herstellverfahren mit den Merkmalen des Patentanspruchs 5 gelöst.

Die Erfindung beruht darauf, bei einem MOS-Transistor in einer Ein-Transistor-Speicherzelle mit einem als Oxidationsbarriere wirkenden isolierenden Spacer eine Verdickung des Gateoxids im Bereich unter einer Seitenwand des Gates , d.h. einen sogenannten bird's beak, vorzusehen. Das Herstellverfahren sieht vor, die Verdickung des Gateoxids vor der Herstellung der isolierenden Spacer zu erzeugen. Nach der Ätzung des Gates wird ein Oxidationsschritt durchgeführt, der zu einer Verdickung des Gateoxids unter der Seitenwand des Gates führt. Danach wird an der Seitenwand des Gates ein isolierender Spacer erzeugt, der Nitrid oder ein anderes als Oxidationsbarriere wirkendes Material umfaßt bzw. daraus besteht. Schließlich wird der MOS-Transistor in bekannter Weise fertiggestellt (insbesondere durch Implantation der dotierten Bereiche).

Der Einsatz eines bird's beak bei MOS-Transistoren ist bspw. aus US 5 306 655 zur Verringerung des hot-electron-Effektes bekannt, die dort beschriebenen Transistoren werden seitlich durch Oxid-Spacer isoliert.

Die zur Bildung des bird's beak notwendige laterale Komponente der Oxidation wird durch Wahl geeigneter Prozeßbedingungen hergestellt, beispielsweise durch eine relativ niedrige Oxidationstemperatur im Bereich von 700 bis 900°C, wobei eine Temperatur von ca. 800°C bevorzugt wird, und/oder durch Zusatz von Wasserstoff oder einer Wasserstoffverbindung bei mindestens einem Teil des Oxidationsschrittes (sog. wet oxidation).

Um eine ungewollte zu starke Oxidation der Gatebahnen selbst zu vermeiden, ist es je nach Material des Gates vorteilhaft, die freiliegende Seitenwand vor dem Oxidationsschritt in geeigneter Weise zu passivieren. Dazu kann beispielsweise ein kurzer Hochtemperaturschritt, eventuell unter Zusatz von Sauerstoff, eingesetzt werden. Der bevorzugte Temperaturbereich ist 1000°C bis 1150°C. Eine weitere Möglichkeit für die Passivierung ist die Abscheidung von Oxid, das dann vor der bird's beak-Herstellung bei hohen Temperaturen in Stickstoffhaltiger Atmosphäre getempert wird. Inwieweit eine Passivierung erforderlich ist, ist insbesondere vom Gate-Material abhängig. Bei lediglich aus Polysilizium bestehenden Gates kann die Passivierung entfallen, bei Gates, die eine Wolframsilizidschicht enthalten, ist eine Passivierung im allgemeinen notwendig. Das Gate kann als mehrschichtiger Gatestack aufgebaut sein.

Mit dem erläuterten Verfahren wird ein bird's beak an beiden Seiten des Gates erzeugt. Durch geeignete Modifikation des Prozesses (Abdeckung an einer Seite des Gates) kann aber auch ein einseitiger bird's beak hergestellt werden.

Vor dem Oxidationsschritt können Reinigungsschritte durchgeführt werden.

Mit dem Verfahren kann auch ein LDD-Transistor hergestellt werden, indem nach dem Oxidationsschritt und vor der Herstellung des isolierenden Spacers eine LDD-Implantation durchgeführt wird.

Die Erfindung wird im folgenden anhand von Ausführungsbeispielen, die in den Zeichnungen dargestellt sind, näher erläutert. Es zeigen:

FIG 1 bis 3 einen Querschnitt durch ein Halbleitersubstrat, an dem die Verfahrensschritte gemäß eines Ausführungsbeispiels verdeutlicht werden, wobei der Übersichtlichkeit wegen lediglich der Transistorbereich der Ein-Transistor-Speicherzelle dargestellt ist,

FIG 4 einen Querschnitt durch eine DRAM-Speicherzelle mit einem erfindungsgemäß hergestellten MOS-Auswahltransistor.

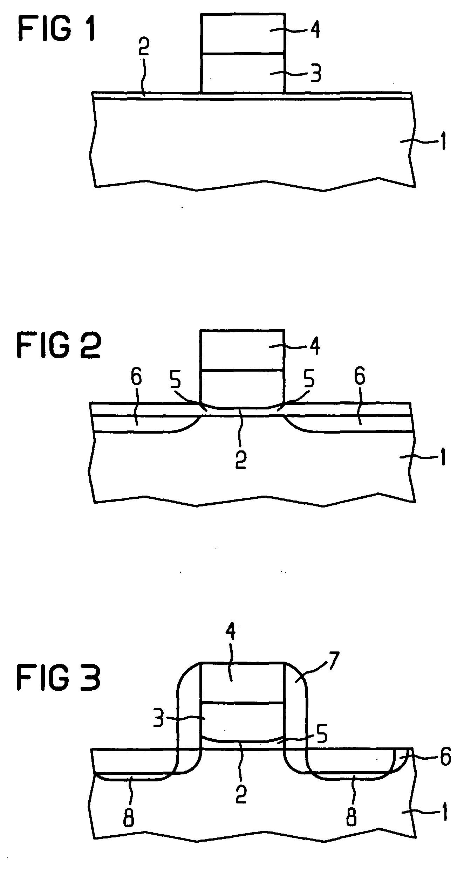

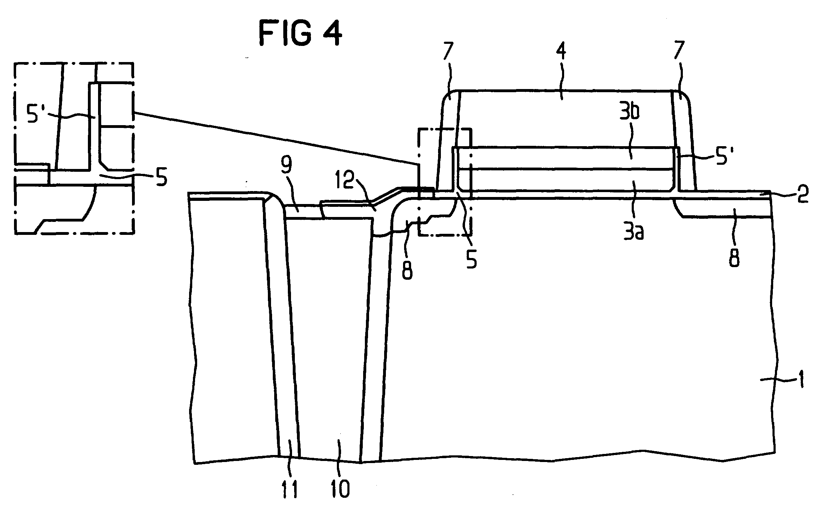

FIG 1: Auf einem Halbleitersubstrat 1 sind mit bekannten Verfahren ein Gateoxid 2, ein Gate 3 beispielsweise aus Polysilizium und eine isolierende Gateabdeckung 4 hergestellt. In diesem Ausführungsbeispiel besteht die Gateabdeckung aus Nitrid. Auch außerhalb des vom Gate bedeckten Bereichs bleibt das Gateoxid im allgemeinen auf der Substratoberfläche. Ferner umfaßt das Substrat (wie in Fig.4 dargestellt) einen Grabenkondensator, dessen Speicherelektrode mit dem Transistor zu verbinden ist.

FIG 2: Nach eventuellen Reinigungsschritten erfolgt ein Oxidationsschritt, der nach einem üblichen langsamen Hochrampen (z.B. 5°/min) beispielsweise mit folgenden Schritten abläuft:
Temperatur: 800°C , Gase: 61/min O₂, Zeit: 10min -
800°C, 61/min O₂ und 3,61/min H₂, 7 min ;
800°C, 61/min O₂, 5 min ;
800°C, 201/min O₂ ;
N₂-Spülung und Herunterrampen.
Dadurch wird im Bereich unter der Seitenwand des Gates ein bird's beak 5 erzeugt, dessen laterale Ausdehnung mit Hilfe der Prozeßparameter und der Oxidationszeit eingestellt werden kann. Es kann eine LDD-Implantation mit einem Dotierstoff des vom Substrat 1 entgegengesetzten Leitungstyps erfolgen, so daß LDD-Gebiete 6 im Substrat erzeugt werden.
In Abhängigkeit vom Gatematerial kann es vorteilhaft oder erforderlich sein, vor dem Oxidationsschritt einen Passivierungsschritt, wie er bspw. im zweiten Ausführungsbeispiel näher beschrieben ist, durchzuführen.

FIG 3: An der Seitenwand des Gates (hier an beiden Seitenwänden) werden mit bekannten Verfahren isolierende Spacer 7 aus einem als Oxidationsbarriere wirkenden Material, insbesondere aus Nitrid, erzeugt. Der MOS-Transistor wird durch Herstellung der dotierten Gebiete 8 (Source und Drain) fertiggestellt.

FIG 4: Der Querschnitt (mit gleichen Bezugszeichen wie in Fig. 1 - 3) zeigt einen Ausschnitt aus einer DRAM-Grabenzelle mit einem mit Polysilizium 10 aufgefüllten Graben im Substrat 1.In der linken Bildhälfte ist ein vergrößerter Ausschnitt der Gateseitenwand gezeigt. Der Graben wird mit bekannten Verfahren unter Verwendung einer Grabenmaske hergestellt. Die Grabenwand ist mit einer Isolationsschicht 11 bedeckt, dann wird der Graben mit dotiertem Polysilizium 10 als Speicherelektrode aufgefüllt. In vielen Fällen (hier nicht dargestellt) ist die Isolationsschichtt 11 im oberen Bereich des Grabens dicker (sog. Oxide collar) als im unteren Bereich, wo sie das eigentliche Kondensatordielektrikum bildet. Der Graben wird an der Substratoberfläche mit einer Isolierung 9 abgedeckt, die vorzugsweise gleichzeitig mit Isolationsgebieten zwischen benachbarten Speicherzellen (z.B Shallow Trench Isolation) erzeugt wird. Dann werden das Gateoxid 2 und das Gate 3 gebildet. Das Gate ist als mehrschichtiger Gatestack bestehend aus Polysilizium 3a und Wolframsilizid 3b ausgebildet, die isolierende Gateabdeckung 4 besteht ganz oder teilweise aus Siliziumnitrid. Bis zu diesem Punkt kann die Herstellung mit üblichen Verfahren erfolgen.

Dann wird zunächst ein Passivierungsschritt durchgeführt, der zu einer dünnen Oxidschicht 5' an den Gateseitenwänden führt. Der Passivierungsschritt läuft vorzugsweise mit folgenden Schritten ab:
Hochrampen mit 20°C/s bis auf 1090°C in N₂ 51/min ;
Temperatur: 1090°C , Gase: 51/min N₂, Zeit: 10 sec ;
1090°C, 4,81/min N₂ und 0,31/min O₂, 5 sec ;
1090°C, 1,31/min N₂ und 41/min O₂ , 12 sec ;
1090°C, 51/min O₂ , 33 sec ;
Herunterrampen unter O₂
Dabei können die Parameter variiert werden. Ein langsamer Übergang von N₂ zu O₂ ist jedoch vorteilhaft, wobei die zu wählenden Zeiten von der verwendeten Anlage abhängig sind. Nach der Passivierung der Seitenwände durch die dünne Oxidschicht 5' erfolgt der Oxidationsschritt, der wie vorstehend beschrieben durchgeführt werden kann und den bird's beak 5 erzeugt

Anschließend werden mit bekannten Verfahren Nitrid-Spacer 7 an der Gateseitenwand gebildet, die Implantation von Source und Drain kann vorher und/oder nachher erfolgen, insbesondere können LDD-Transistoren gebildet werden. Nach Fertigstellung des Transistors wird die Isolationsschicht 9 an der Grabenoberseite lokal weggeätzt und es wird ein sogenannter surface strap 12 als Kontakt zwischen Auswahltransistor und Speicherelektrode erzeugt. Dies geschieht vorzugsweise durch Abscheiden einer undotierten Siliziumschicht, die über der Öffnung in der Isolationsschicht 9 durch Ausdiffusion aus der Elektrode 10 dotiert wird. Danach kann das verbleibende undotierte Silizium selektiv zu dem dotierten 12 entfernt werden. Schließlich wird die Oberfläche des surface strap 12 oxidiert, so daß dieser nach oben isoliert ist. Aufgrund der Nitridspacer erfolgt dabei keine weitere Oxidation des Gateoxids .

Die Erfindung ist auch einsetzbar bei anderen DRAM-Speicherkonzepten, bspw. mit buried strap wie in US 5 360 758 beschrieben. Der Einsatz des bird's beak ist bei DRAM's mit großen Vorteilen verbunden, weil hier auch geringe Leckströme, insbesondere geringere als in Logik-Schaltungen, schon kritisch sind.

## Patentansprüche

1. MOS-Transistor in einer Ein-Transistor-Speicherzelle mit
- einem ersten und Zweiten leitenden Gebiet (8) in einem Halbleitersubstrat (1),
- einem Gate (3), das auf der Substratoberfläche zwischen dem ersten und zweiten leitenden Gebiet angeordnet ist,
- einem Gateoxid (2), das das Gate (3) vom Halbleitersubstrat (1) isoliert und eine Verdickung (5) im Bereich unter einer Seitenwand des Gates (3) aufweist, und
- einem isolierenden Spacer (7) an der Seitenwand des Gates (3), der ein als Oxidationsbarriere wirkendes Material umfaßt.

2. MOS-Transistor nach Anspruch 1, bei dem der isolierende Spacer (7) aus Siliziumnitrid besteht.

3. MOS-Transistor nach einem der Ansprüche 1 bis 2, bei dem das Gate (3) eine Wolframsilizidschicht (3b) und/oder eine Polysiliziumschicht (3a) umfaßt.

4. MOS-Transistor nach einem der Ansprüche 1 bis 3, bei dem der MOS-Transistor den Auswahltransistor einer DRAM-Speicherzelle bildet.

5. Herstellverfahren für einen MOS-Transistor in einem Halbleitersubstrat (1) nach einem der Ansprüche 1 bis 4 mit folgenden Schritten:
- Erzeugen eines Gateoxids (2) und eines darüberliegenden Gates (3) auf dem Halbleitersubstrat (1),
- Durchführen eines Oxidationsschritts, so daß unter einer Seitenwand des Gates (3) eine Verdickung (5) gebildet wird,
- nachfolgende Erzeugung eines isolierenden Spacers (7) an der Seitenwand des Gates (3), der ein als Oxidationsbarriere wirkendes Material umfaßt,
- Erzeugen von dotierten Gebieten (8) des MOS-Transistors benachbart zum Gate (3).

6. Herstellverfahren nach Anspruch 5, bei dem der Oxidationsschritt bei einer Temperatur im Bereich 700 bis 900°C und/oder als Feuchtoxidation durchgeführt wird.

7. Herstellverfahren nach einem der Ansprüche 5 bis 6, bei dem der isolierende Spacer (7) Siliziumnitrid enthält.

8. Herstellverfahren nach einem der Ansprüche 5 bis 7, bei dem nach dem Oxidationsschritt eine LDD-Implantation durchgeführt wird.

9. Herstellverfahren nach einem der Ansprüche 5 bis 8, bei dem vor dem Oxidationsschritt ein Passivierungsschritt zur Passivierung der Seitenwand des Gates (3) durchgeführt wird.

10. Herstellverfahren nach einem der Anspruch 9, bei dem vor dem als Passivierungsschritt ein Hochtemperaturschritt durchgeführt wird.

11. Herstellverfahren nach einem der Ansprüche 5 bis 10, bei dem zur Herstellung des Gates (3) eine Wolframsilizidschicht (3b) gebildet wird.
